# EUROPEAN PATENT APPLICATION

(11) **EP 0 566 253 A1**
(43) Date of publication of application: **20.10.1993**
(21) Application number: 93302154.5
(22) Date of filing: 22.03.1993
(51) Int. Cl.: H01L 23/485, H01L 21/60

(54) **Method for forming contact structures in integrated circuits**

(30) Priority: 31.03.1992 US 860979
(71) Applicant: SGS-THOMSON MICROELECTRONICS, INC., Carrollton Texas 75006 (US)
(72) Inventor: Chen, Fusen E., Milpitas, California 95035 (US); Liou, Fu-Tai, Denton County, Texas 75010 (US); Dixit, Girish A., Denton County, Texas 75287 (US)
(74) Representative: Palmer, Roger

(57) **Abstract**

A contact structure and method for forming contact structures in integrated circuits. An opening is formed through an insulating layer (14) where a contact is to be formed, exposing an underlying region in the integrated circuit. A conductive plug (24,26) is formed in the opening, and partially fills the opening. The conductive plug makes electrical contact with the exposed underlying region in the opening. A barrier layer (28) is then formed over the insulating layer and extends into the opening to cover the conductive plug. A conductive layer (30,32) is formed over a portion of the insulating layer and extends into the opening to fill the opening and make electrical contact with the barrier layer and conductive plug.

## Description

The present invention relates generally to integrated circuits, and more particularly to a contact structure and a method for forming contact structures in integrated circuits.

Complex integrated circuits require multiple layers of material to fabricate the various components on the integrated circuit. Contact vias of varying sizes are formed between the layers to connect one layer to another. Several problems arise when forming contacts in integrated circuits having multiple layers and contact vias of assorted sizes. First, forming reliable contacts can be a problem when the contact vias are of differing sizes and depths. The material used to form the contact may not completely fill the contact via. This step coverage problem creates voids and other defects in the contact.

Second, maintaining the planarity of the integrated circuit is a concern during fabrication of the layers and contacts. Contact vias may be over and under filled as a result of their differing sizes. Thus, additional processing steps may be needed to maintain the planarity of the device. For example, an etching step may be required to remove excess materials.

One method used to form contacts in an attempt to avoid these problems is selective deposition of a metal, such as tungsten. However, selective deposition is not entirely successful in eliminating the problems. Contact vias of different sizes and depths are still difficult to fill completely. The contact vias may be over and under filled, thus requiring an etching step to remove the excess material.

Therefore, it would be desirable to provide a method for forming contact structures in integrated circuits where the contact vias are not over and under filled. It is also desirable that such a method not significantly increase the complexity of the fabrication process.

The present invention discloses a contact structure and a method for forming contact structures in integrated circuits. An opening is formed through an insulating layer where a contact is to be formed, exposing an underlying region in the integrated circuit. A conductive plug is formed in the opening, and partially fills the opening. The conductive plug makes electrical contact with the exposed underlying region in the opening. A barrier layer is then formed over the insulating layer and extends into the opening to cover the conductive plug. Aconductive layer is formed over a portion of the insulating layer and extends into the opening to fill the opening and make electrical contact with the barrier layer and conductive plug.

The novel features believed characteristic of the invention are set forth in the appended claims. The invention itself however, as welt as a preferred mode of use, and further objects and advantages thereof, will best be understood by reference to the following detailed description of an illustrative embodiment when read in conjunction with the accompanying drawings, wherein:

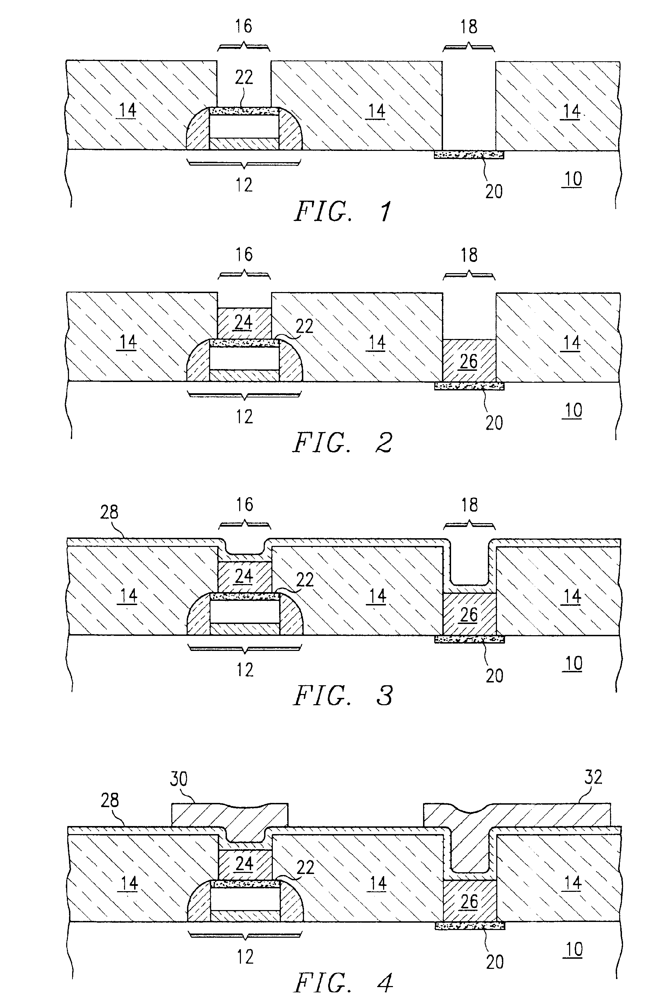

Figures 1-4 are sectional views of an integrated circuit illustrating a preferred method for forming contact structures in integrated circuits according to the present invention.

The process steps and structures described below do not form a complete process flow for manufacturing integrated circuits. The present invention can be practiced in conjunction with integrated circuitfab- rication techniques currently used in the art, and only so much of the commonly practiced process steps are included as are necessary for an understanding of the present invention. The figures representing cross- sections of portions of an integrated circuit during fabrication are not drawn to scale, but instead are drawn so as to illustrate the important features of the invention.

Referring to Figure 1, an integrated circuit will be formed on a semiconductor substrate 10. Structure 12 is fabricated on the substrate 10, and may be either a gate electrode or an interconnect layer. An insulating layer 14 is deposited over the integrated circuit. In the preferred embodiment, the insulating layer 14 is made of spin on or reflow glass, but can be made from other materials. For example, a multilayer comprising spin on glass overlying an undoped oxide may be used. Contact via 16 is then formed through the insulating layer 14 to expose a portion of the contact structure 12. Contact via 18 is also formed through the insulating layer 14 to expose a portion of the substrate 10. Contact vias 16, 18 are preferably created by performing an anisotropic etch.

Silicided areas 20, 22 are formed in the exposed portions of the substrate 10 and structure 12. In the preferred embodiment, silicided areas 20, 22 are created by depositing titanium overthe integrated circuit. The titanium is then annealed as known in the art to form titanium silicide. Alternatively, a SALICIDE process may be used before the insulating layer 14 is deposited. Those skilled in the art will recognize this will form silicided areas in all the active areas in the substrate 10, not just in the contact vias 16, 18.

Figure 2 illustrates the integrated circuit after a metal is selectively deposited into the contact vias 16, 18 to form conductive plugs 24, 26. In the preferred embodiment, conductive plugs 24, 26 are made of tungsten, but other materials can be used. As can be seen, the conductive plugs 24, 26 only partially fill the contact vias 16, 18. Since contact via 16 is not as deep, it is more completely filled. Conductive plugs 24, 26 should be thick enough to provide a substantial amount of material to fill in deeper openings preferably without overfilling the shallow ones.

Referring to Figure 3, a barrier layer 28 is deposited over the integrated circuit. The barrier layer 28 is preferably made of a refractory metal, such as titanium or titanium nitride, but other materials can be used. For example, the barrier layer 28 may be made of a combination of titanium, titanium nitride, and titanium silicide.

Figure 4 illustrates the integrated circuit after a conductive layer is deposited and patterned on the device, creating conductive contacts 30, 32. In the preferred embodiment, conductive contacts 30, 32 are made of aluminum or an aluminum alloy, but other materials can be used. As can be seen, the material in the conductive contacts 30, 32 completely fills contact vias 16, 18. Step coverage problems are minimized in the present invention because contact vias 16,18 are partially filled with conductive plugs 24, 26 before the conductive contacts 30, 32 are formed. Conductive plugs 24, 26 minimize the step height in the vias, even for deeper vias.

While the invention has been particularly shown and described with reference to a preferred embodiment, it will be understood by those skilled in the art that various changes in form and detail may be made therein without departing from the spirit and scope of the invention.

## Claims

1. A method for forming contact structures in integrated circuits, comprising the steps of:
forming an opening through an insulating layer where a contact will be formed, wherein a portion of an underlying region in the integrated circuit is exposed;
forming a first conductive layer in the opening, wherein the first conductive region partially fills the opening to form a conductive plug, and the conductive plug makes electrical contact with the underlying region;
forming a first conductive layer over a portion of the insulating layer and extending into the opening, wherein the first conductive layer fills the opening and makes electrical contact with the conductive plug.

2. The method of Claim 1, further comprising the step of depositing titanium into the opening to form a silicided area in the underlying region before the first conductive region is formed.

3. The method of Claim 1, further comprising the step of forming a barrier layer over the insulating layer and extending into the opening before the step of forming a first conductive layer is performed.

4. The method of Claim 3, wherein said step of forming the barrier layer comprises depositing a layer of a refractory metal over the insulating layer and extending into the opening to cover the conductive plug.

5. The method of Claim 4, wherein the barrier layer comprises titanium or titanium nitride.

6. The method of Claim 4, wherein the barrier layer comprises a combination oftitanium, titanium nitride and titanium silicide.

7. The method of Claim 1, wherein said step of forming the opening comprises anisotropically etching the insulating layer to expose a portion of the underlying region in the integrated circuit where a contact will be formed.

8. The method of Claim 1, wherein said step of forming the first conductive region comprises selectively depositing tungsten into the opening.

9. The method of Claim 1, wherein said step of forming the first conductive layer comprises depositing and patterning a layer of aluminum or aluminum alloy over a portion of the insulating layer and extending into the opening, wherein the aluminum fills the opening and makes electrical contact with the conductive plug.

10. A contact structure in an integrated circuit, comprising:
an insulating layer overlying an underlying region in the integrated circuit;
an opening through the insulating layer to expose a portion of the underlying region;
a conductive plug in the opening, wherein the conductive plug partially fills the opening and makes electrical contact with the underlying region;
a barrier layer overlying the insulating layer and extending into the opening to cover the conductive plug; and
a conductive layer overlying portions of the insulating layer and extending into the opening, wherein the conductive layerfills the opening and makes electrical contact with the barrier layer and conductive plug.

11. The contact structure of Claim 10 further comprising a silicided area in the underlying region exposed in the opening.

12. The contact structure of Claim 15 wherein the silicided area comprises a titanium silicide.

13. The method of Claim 7, or the contact structure of Claim 10, wherein the insulating layer is made of spin on glass.

14. The method of Claim 7, or the contact structure of Claim 10, wherein the insualting layer is made of reflow glass.

15. The method of Claim 7, or the contact structure of Claim 10, wherein the underlying region comprises a semiconductor substrate.

16. The contact structure of Claim 10 wherein the underlying region comprises an interconnect layer.

17. The contact structure of Claim 10 wherein the conductive plug is formed by selective deposition of a metal into the opening.

18. The contact structure of Claim 17 wherein the conductive plug is made of tungsten.

19. The contact structure of Claim 10 wherein the barrier layer is made of a refractory metal.

20. The contact structure of Claim 19 wherein the barrier layer is made of titanium.

21. The contact structure of Claim 19 wherein the barrier layer is made of a combination of titanium, titanium nitride, and titanium silicide.

22. The contact structure of Claim 10 wherein the conductive layer is made of aluminum.
